# EUROPEAN PATENT APPLICATION

(11) **EP 1 895 600 A1**
(43) Date of publication of application: **05.03.2008**
(21) Application number: 06766903.6
(22) Date of filing: 19.06.2006
(51) Int. Cl.: H01L 33/00, H01L 23/29, H01L 23/31

(54) **WHITE SEMICONDUCTOR LIGHT EMITTING ELEMENT AND MANUFACTURING METHOD THEREOF**

(30) Priority: 20.06.2005 JP 2005179659; 20.06.2005 JP 2005179660
(71) Applicant: ROHM CO., LTD., Kyoto-shi, Kyoto 615-8585 (JP)
(72) Inventor: NISHIHARA, Taihei c/o ROHM CO., LTD., , Kyoto-shi, Kyoto 6158585 (JP)
(74) Representative: TBK-Patent
(86) International application number: PCT/JP2006/312239
(87) International publication number: WO 2006/137359

(57) **Abstract**

An LED chip (2) emitting blue light is mounted on an insulating substrate (1) at both ends of which electrode films (11, 12) are formed, and a pair of electrodes of the LED chip (2) is electrically connected to the pair of electrode films (11, 12) respectively by connection means (3). On the LED chip (2), there are provided a first resin layer (4) made of resin containing a red color conversion member (4a) for converting blue light into red light and provided so as to coat substantially half of the LED chip (2) and to be in close contact with the LED chip (2), and a second resin layer (5) made of resin containing a green color conversion member (5a) for converting blue light into green light and provided so as to coat similarly the other substantially half of the LED chip (2). As a result, it is possible to attach the resin containing light color conversion members directly to the LED chip in such manner that the red and green light color conversion members are not mixed with each other and obtain a white semiconductor light emitting device having high external quantum efficiency.

## Description

### FIELD OF THE INVENTION

The present invention relates to a white semiconductor light emitting device emitting white light, which is formed by using a light emitting element chip emitting blue or ultraviolet light and a light color conversion member for converting the blue or ultraviolet light into red or green light or the like, and to a method for manufacturing the same. More particularly, the present invention relates to a white semiconductor light emitting device in which white light with high luminance can be obtained by converting into white light efficiently with not occurring a useless conversion such as converting green light or the like converted into red light further, and to a method for manufacturing the same.

### BACKGROUND OF THE INVENTION

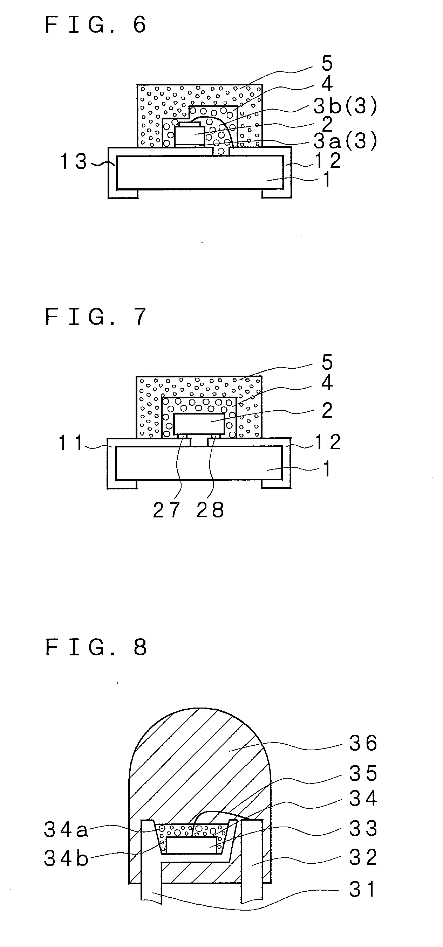

For example, a white semiconductor light emitting device using a light emitting element chip (LED chip) by the prior art is formed, as shown in Fig. 8, by coating a LED chip 33 emitting blue light with a fluorescent layer 34 deposited thereon and coating a surrounding thereof with a transparent resin 36 (cf. for example PATENT DOCUMENT 1). In Fig. 8, numerals 31 and 32 represent a pair of leads, the LED chip 33 is bonded within a recess of one lead 31, and the other electrode is connected to the other lead 32 with a wire 35, thereby a light emitting device of a lamp type is constituted. However, in such white light emitting device, since a red fluorescent material 34a and a green fluorescent material 34b are mixed in the fluorescent layer 34, light converted into green light is absorbed by the red fluorescent material 34a and converted further into red light, then, there arise problems such that stable white color of emitted light can not be obtained because a ratio of light to be mixed can not be constant, and such that luminance is deteriorated because light is attenuated by being absorbed by the fluorescent layer 34 many times, because conversion efficiency of the fluorescent material is not 100%.

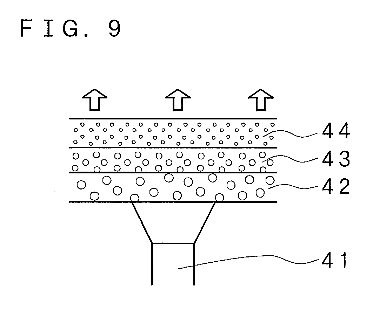

In order to solve such problems, a white light emitting device is known having a structure in which a red fluorescent material contained layer 42, a green fluorescent material contained layer 43, and a blue fluorescent material contained layer 44 are laminated separately, as shown, for example, in Fig. 9, or arranged in plane separately, above a light source 41 of ultraviolet light, thereby light converted into green light or blue light is prevented from being converted further by the red fluorescent material contained layer 42 or the like (cf. for example PATENT DOCUMENT 2).
PATENT DOCUMENT 1: Japanese Patent Application Laid-Open No. 2004-327518
PATENT DOCUMENT 2: Japanese Patent Application Laid-Open No. 2004-071357

### DISCLOSURE OF THE INVENTION

### PROBLEM TO BE SOLVED BY THE PRESENT INVENTION

As described above, in order to obtain a white light emitting device, a method is used in which white color is obtained by generating light having three primary colors of red, green and blue and mixing them by coating a LED emitting blue light with fluorescent materials converting blue light into green light and red light, or by coating a LED emitting ultraviolet light with fluorescent materials converting ultraviolet light into red light, green light and blue light. In this case, when a mixture of red and green fluorescent substances is used, there arise problems such that attenuation of light becomes much and, at the same time, a quantity of conversion into each color is not constant, because light converted into green light is converted into red light again, or the like. In addition, even if each fluorescent layer is provided separately, there occurs a problem such that external quantum efficiency is lowered not only because loss increases by increase of number of the fluorescent layers, but also because light is attenuated by reflection between the LED and the fluorescent layers, or the like, when the fluorescent layers are provided apart from the LED.

The present invention is directed to solve the above-described problems and objects of the present invention are to provide a white semiconductor light emitting device capable of improving external quantum efficiency by depositing resins containing light color conversion members directly on a LED so as to prevent each of the light color conversion members from being mixed with each other, and to provide a method for manufacturing the same.

### MEANS FOR SOLVING THE PROBLEM

It is found that, in order to form a light emitting device emitting white light by using, for example, a light emitting device emitting blue light and resins containing light color conversion members as described above, it is most preferable to deposit resins containing light color conversion members directly around a LED chip without mixing each light color conversion member, for improving external quantum efficiency. However, since a size of the LED chip is very small such as approximately 0.3 millimeter cube, it is very difficult to deposit, for example, a resin containing green color conversion member and a resin containing red color conversion member separately and with a desired quantity. Then, the present inventor studied and examined earnestly and repeatedly, and, as a result, it is found that, by attaching a resin containing a light color conversion member to a transfer pin and transferring it on a side of a light emitting element chip, the resin can be deposited without mixing of the resin containing red color conversion member and the resin containing green color conversion member, and with a precise adjustment of a quantity which can be achieved by adjusting a thickness of the transfer pin, and both resins can be deposited directly even on a small chip and almost independently, thereby a white semiconductor light emitting device with very high external quantum efficiency can be obtained.

As a result of further earnest and repeated studies and examinations by the present inventor, it is also found that, by coating firstly a LED with a first resin layer by molding with a resin containing a red color conversion member, and forming a second resin layer by molding with a resin containing a green color conversion member, each of them can be formed with a very thin layer independently, and a white semiconductor light emitting device with very high external quantum efficiency can be obtained.

A white semiconductor light emitting device according to the present invention includes an insulating substrate which is provided with a pair of electrode films at both ends thereof, a light emitting element chip emitting blue light mounted on the insulating substrate, connection means connecting electrically a pair of electrodes of the light emitting element chip and the pair of electrode films of the insulating substrate respectively, a first resin layer made of resin containing a red color conversion member for converting the blue light emitted by the light emitting element chip into red light, and provided so as to coat substantially half of the light emitting element chip and to be in close contact with the light emitting element chip, and a second resin layer made of resin containing a green color conversion member for converting the blue light emitted by the light emitting element chip into green light, and provided so as to coat the other substantially half of the light emitting element chip and to be in close contact with the light emitting element chip.

A structure may be used in which the pair of electrodes of the light emitting element chip is formed at a surface side, the pair of electrodes of the light emitting element chip is connected directly to the pair of electrode films with conductive an adhesive by turning a back surface of a substrate of the light emitting element chip upside, and the first and second resin layers are provided so as to coat the back surface of the substrate of the light emitting element chip.

A white semiconductor light emitting device of another embodiment, according to the present invention includes a first lead which is provided with a recess of a curved shape at an end part thereof, a second lead arranged in parallel to the first lead, a light emitting element chip emitting blue light mounted in the recess of the first lead, connection means connecting electrically a pair of electrodes of the light emitting element chip and the first and second leads respectively, a first resin layer made of resin containing a red color conversion member for converting the blue light emitted by the light emitting element chip into red light, and provided so as to coat substantially half of the light emitting element chip and to be in close contact with the light emitting element chip, and a second resin layer made of resin containing a green color conversion member for converting the blue light emitted by the light emitting element chip into green light, and provided so as to coat the other substantially half of the light emitting element chip and to be in close contact with the light emitting element chip.

It is preferable that at least one of the connection means is constituted of a wire which connects one electrode of the light emitting element chip and one of the pair of the electrode films or the first and second leads, and the first resin layer and the second resin layer are formed divided approximately by a dividing plane which is perpendicular to a surface of the light emitting element chip in a direction of extending the wire, because an accident such that a wire is touched and broken during forming the first resin layer and the second resin layer is easily prevented.

A white semiconductor light emitting device of still another embodiment, according to the present invention includes an insulating substrate which is provided with a pair of electrode films at both ends thereof, a light emitting element chip emitting blue or ultraviolet light mounted on the insulating substrate, connection means connecting electrically a pair of electrodes of the light emitting element chip and the pair of electrode films of the insulating substrate respectively, a first resin layer made of mold resin containing a red color conversion member for converting the blue or ultraviolet light emitted by the light emitting element chip into red light, and provided to coat a portion of the light emitting element chip and the connection means and a second resin layer made of mold resin containing a green color conversion member for converting the blue or ultraviolet light emitted by the light emitting element chip into green light, and provided to coat a surrounding of the first resin layer.

Here, the white semiconductor light emitting device may be formed such that one of the pair of electrodes which are formed on the light emitting element chip is formed at a back surface side of the chip, thereby one of the connection means is an adhesive with which the light emitting element chip is bonded on one of the pair of electrode films, the other of the connection means is a wire for wire bonding to the other of the pair of electrode films, the first resin layer is formed so as to be thick at a side where the wire for wire bonding exists and thin at a side where the wire does not exist, and the second resin layer is formed so as to be thin at the side where the wire for wire bonding exists and thick at the side where the wire does not exist. By this structure, although a quantity of the resin containing a red color conversion member is increased by wire bonding, a quantity of the resin containing a green color conversion member can be increased correspondingly at a place where the wire does not exist and each color can be balanced evenly with a small quantity of a light color conversion member.

A method for manufacturing a white semiconductor light emitting device according to the present invention is a method for manufacturing a white semiconductor light emitting device in which blue light is converted into white light by providing a resin containing a light color conversion member on a surface of a light emitting element chip emitting blue light, and includes the steps of; forming the light emitting element chip approximately in a shape of a cube or a rectangular solid, forming a first resin layer by contacting a transfer pin with a side or a corner of a surface of the light emitting element chip and by transferring a resin so as to coat substantially half of the light emitting element chip, while the transfer pin is attached with the resin containing a red color conversion member for converting the blue light emitted by the light emitting element chip into red light, and forming a second resin layer by contacting a transfer pin with a side or a corner opposite to the side or the corner of the surface of the light emitting element chip and by transferring a resin so as to coat the other substantially half of the light emitting element chip, while the transfer pin is attached with the resin containing a green color conversion member for converting the blue light emitted by the light emitting element chip into green light.

It is preferable that a wire is bonded on at least one of the electrodes of the light emitting element chip, and the first and second resin layers are formed by contacting the transfer pins with the light emitting element chip from both sides of the wire, because the transfer pin is easily prevented from contacting with the wire.

A method of another embodiment for manufacturing a white semiconductor light emitting device according to the present invention includes the steps of; forming a pair of electrode films on an insulating substrate, mounting a light emitting element chip emitting blue or ultraviolet light on one of the pair of electrode films or a surface of the insulating substrate, connecting electrically a pair of electrodes of the light emitting element chip and the pair of electrode films respectively, forming a first resin layer by molding primarily a surrounding of the light emitting element chip with a resin containing a red color conversion member for converting the blue or ultraviolet light emitted by the light emitting element chip into red light, and forming a second resin layer by molding secondly a surrounding of the first resin layer with a resin containing a green color conversion member for converting the blue or ultraviolet light emitted by the light emitting element chip into green light.

### EFFECT OF THE INVENTION

According to the aspect of the present invention in which each substantially half is coated with a resin, since the resin containing the light color conversion member is directly deposited around the light emitting element chip, blue light emitted by the light emitting element chip can be converted by a small quantity of the light color conversion member. In addition, since the resin containing the red color conversion member and the resin containing the green color conversion member are provided on each substantially half of the light emitting element chip separately, light color once converted into green is not converted into red again and conversion into very stable light color can be achieved. Here, although both of the resins are partially overlapped at their border portion, by depositing the resin containing a red color conversion member first, even if light is converted into red light and the red light transmits through a green color conversion member, the light converted into red light can not be converted into green light again since the green color conversion member does not absorb and transmits light having smaller band gap energy than that of the green color conversion member, namely light having a longer wavelength than that of green color. As a result, a part of light emitted from the light emitting element chip emitting blue light is converted into red light and green light, and white light is obtained by mixing with blue light which is not converted by both light color conversion members. And, since the light color conversion member is minimized, a white semiconductor light emitting device can be formed with small attenuation of light, very high external quantum efficiency, stable light color and good color rendering property.

In addition, according to the another aspect of the present invention in which the resin layers are formed by molding, since a surrounding of the LED chip is directly coated by a molding resin containing a light color conversion member, the surrounding of the LED chip can be coated with a very precise quantity of resin. Further, the first resin layer is formed by molding with the mold resin containing the red color conversion member and the second resin layer is formed by molding again with the resin containing the green color conversion member, thereby the resin layer containing the red color conversion member is formed around the LED chip. Then, a part of blue light or ultraviolet light emitted in the LED chip is converted into red light by the red color conversion member, and the red light and the blue or ultra violet light not converted travel to the second resin layer. Since the second resin layer containing the green color conversion member does not absorb the red light having a longer wavelength than that of the green light, the red light transmits straightly, a part of the blue or ultraviolet light is absorbed by the green color conversion member and converted into the green light, and the green light is emitted. As a result, the red light transmitting the second resin layer, the green light converted by the second resin layer and the blue light which is not absorbed and transmitted are mixed, thereby the white light is emitted from the second resin layer.

In addition, in case of the LED chip emitting ultraviolet light, a third resin layer containing a blue color conversion member is provided on an external periphery of the second resin layer, thereby three primary colors, red, green and blue, are mixed and the white light can be obtained.

By the manufacturing method by coating the resin according to the present invention, since the resin is deposited by the transfer method in which a transfer pin is contacted directly with a side or angle part of the light emitting element chip, a depositing quantity or a depositing position can be adjusted very precisely by adjusting a thickness of the transfer pin. As a result, a quantity of a minimum essential of the resin can be deposited, useless absorption of the light decreases, and the white light emitting device with remarkably high external quantum efficiency can be obtained. In addition, even in case that the wire exists on the surface of the light emitting element chip, since the transfer pin can be brought close to the light emitting element chip from the sides interposing the wire, the resin can be deposited without contacting the transfer pin with the wire, reliability of the wire can be improved.

### BRIEF DESCRIPTION OF THE DRAWINGS

Fig. 1 is an explanatory cross-sectional view showing a manufacturing process of an embodiment of the white light emitting device according to the present invention.
Fig. 2 is an explanatory cross-sectional view showing an example of a LED chip of the light emitting device shown in Fig. 1.
Fig. 3 is an explanatory cross-sectional view showing another embodiment of the white light emitting device according to the present invention.
Fig. 4 is an explanatory cross-sectional view showing a variation example of Fig. 1.
Fig. 5 is an explanatory cross-sectional view showing a manufacturing process of still another embodiment of the white light emitting device according to the present invention.
Fig. 6 is an explanatory cross-sectional view showing a variation example of Fig. 5.
Fig. 7 is an explanatory cross-sectional view showing another variation example of Fig. 5.
Fig. 8 is a figure showing one constitution of a white light emitting device by the prior art.
Fig. 9 is an explanatory figure showing an example of another constitution by the prior art for obtaining white light.

### EXPLANATION OF LTTERS AND NUMERALS

- 1:: insulating substrate
- 2:: LED chip
- 3:: connection means
- 4:: first resin layer
- 4a:: red color conversion member
- 5:: second resin layer
- 5a:: green color conversion member
- 11:: first electrode film
- 12:: second electrode film

### THE BEST EMBODIMENT OF THE PRESENT INVENTION

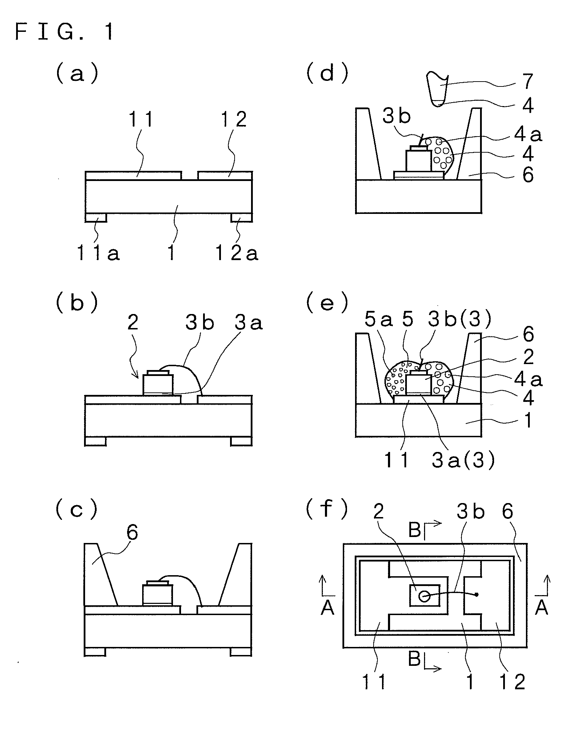

An explanation will be given below of an embodiment of a white semiconductor light emitting device according to the present invention in reference to the drawings. As an explanatory plan view of an embodiment of the white semiconductor light emitting device according to the present invention is shown in Fig. 1(f) and an explanatory cross-sectional view thereof at B-B in Fig. 1(e), a light emitting element chip (hereinafter also referred to as LED chip) 2 emitting blue light is mounted on a substrate 1 which is provided with a pair of electrode films 11 and 12 at both ends thereof and a pair of electrodes of the LED chip 2 is connected electrically to the pair of electrode films (first and second electrode films) 11 and 12 by connection means 3. On the LED chip 2, there are formed a first resin layer 4 made of resin containing a red color conversion member 4a for converting the blue light emitted by the LED chip 2 into red light, which is provided so as to coat only a surround of substantially (about) half of the LED chip 2 and to be in close contact with the LED chip 2, and a second resin layer 5 made of a resin containing a green color conversion member 5a for converting the blue light emitted by the LED chip 2 into green light, which is provided so as to coat only a surrounding of the other substantially half of the LED chip 2 and to be in close contact with the LED chip 2.

The first resin layer 4 is formed by depositing a material which is made by mixing a red color conversion member 4a absorbing light having a shorter wavelength than that of the red light and converting into the red light to a usual light transmitting resin, for example, such as an epoxy resin or a silicone resin, for example, by a transfer method. A light color conversion member absorbs the light having larger band gap energy than that thereof, or the light having a shorter wavelength than that corresponding to the band gap energy thereof, and emits light corresponding to the band gap energy thereof. And as the red color conversion member 4a, a fluorescent material such as yttrium oxide activated by europium or complex oxide thereof, or nitride or sulfide activated by europium, or the like may be used. As described above, the light color conversion member absorbs light having a shorter wavelength than that corresponding to the band gap energy thereof. Therefore, since a portion of overlapping exists at a boarder even if the first resin layer 4 is provided at a different place from a second resin layer described later, a resin containing the red color conversion member 4a converting into red light which has the longest wavelength among red, green and blue light of three primary light colors is used as the first resin layer 4, and deposited first on the LED chip 2 in the present invention. As a result, although the portion of overlapping of the second resin layer 5 exists, the red light which is obtained by absorbing a part of the blue light emitted in the LED chip 2 and converting into the red light is not absorbed by the second resin layer 5.

As the second resin layer 5, a material which is made by mixing a green color conversion member 5a to a light transmitting resin such as an epoxy resin, a silicone resin or the like in the same manner, is used. As the green color conversion member 5a, for example, an alkaline-earth aluminate fluorescent material activated by bivalent manganese and europium, a rare-earth silicate fluorescent material activated by trivalent cerium, or the like may be used. The first and second resin layers 4 and 5 can be deposited separately on the LED chip 2 with a correct quantity by a transfer method even if the LED chip 2 is very small.

As the substrate 1, although same material as that used for a substrate for a usual chip type light emitting device may be used, a substrate made of, for example, alumina, BT resin or the like and having a thickness of approximately 0.1 to 0.5 mm can be used. A substrate for a light emitting device shown in Fig. 1(f) is formed in a size which has (length) × (width) × (height) of (0.6 to 1 mm) × (1.5 to 4 mm) × (0.3 to 1 mm), however a plurality of the substrates are processed in a state of a large substrate of approximately 10 cm × 5 cm at one time in a manufacturing stage. On a surface of the large substrate, a plurality of the pairs of electrode films 11 and 12 made of Ag, Au or the like is formed together by printing, on a back surface of the substrate 1, back surface electrode films 11a and 12a are formed, and the electrode films 11 and 12 of the surface are connected to the back surface electrode films 11a and 12a with side electrode films 11b and 12b which are provided on sides after dividing into each device.

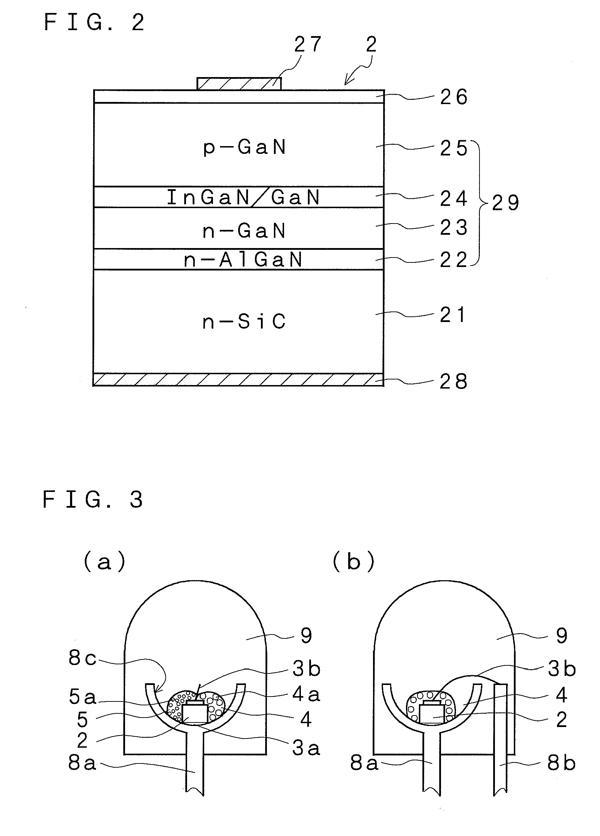

A LED chip 2 emitting blue light is used in the example shown in Fig. 1, and the LED chip using nitride semiconductor is formed as an example of a cross-sectional constitution is shown in, for example, Fig. 2. However the example is not limited to nitride semiconductor, and zinc oxide based (ZnO based) compound or the like can be used. The LED chip 2 is formed, for example, in a size which has (length) × (width) × (height) of approximately (0.3 mm) × (0.3 mm) × (0.15 mm). Here, the nitride semiconductor means a compound of Ga of group III element and N of group V element or a compound (nitride) in which a part or all of Ga of group III element is substituted by other element of group III element like Al, In or the like and/or a part of N of group V element is substituted by other element of group V element like P, As or the like. And, the zinc oxide based compound means an oxide including Zn, concretely besides ZnO, an oxide of any of elements of group IIA and Zn, of any elements of group IIB and Zn, or of any elements of group IIA and any elements of group IIB and Zn.

As shown in Fig. 2, the LED using nitride semiconductor is provided with a low temperature buffer layer 22 made of, for example, AlGaN based compound (which means that a mixed crystal ratio of Al includes various cases including zero and the same applies hereinafter) and having a thickness of approximately 0.005 to 0.1 µm, for example, on an n-type SiC substrate 21. And, there are laminated on the buffer layer 22 in order, an n-type layer 23 formed with, for example, an n-type GaN layer or the like, of a thickness of approximately 1 to 5 µm, an active layer 24 having a thickness of approximately 0.05 to 0.3 µm formed with a multiple quantum well (MQW) structure which is formed by laminating 3 to 8 pairs of a well layer made of, for example, In_{0.13}Ga_{0.87}N and having a thickness of 1 to 3 nm, and a barrier layer made of GaN and having a thickness of 10 to 20 nm, and a p-type layer 25 formed with, for example, a p-type GaN layer and having a thickness of approximately 0.2 to 0.3, thereby a semiconductor lamination portion 29 is formed. Then, on a surface of the p-type layer 25, a light transmitting conductive layer 26 made of, for example, ZnO is provided with a thickness of approximately 0.1 to 10 µm, on a part of a surface thereof, a p-side electrode 27 is provided with a lamination structure of Ti/Au, Pd/Au or the like with a total thickness of approximately 0.1 to 1 µm, and an n-side electrode 28 is provided on a back surface of the SiC substrate 21 with a lamination structure of Ti/Al or Ti/Au, or the like with a total thickness of approximately 0.1 to 1 µm.

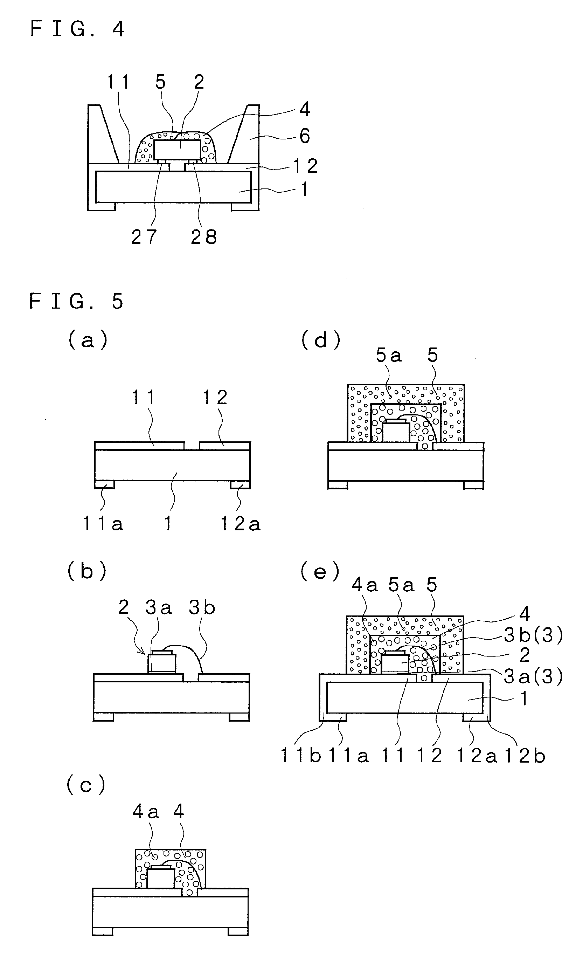

Although the SiC substrate is used as a substrate in the above-described example, not being limited to the material, other semiconductor substrate such as GaN, GaAs or the like can be used and also a sapphire substrate can be used. In case of a semiconductor substrate made of SiC or the like, as shown in Fig. 2, an electrode of one side can be provided on a back surface of the substrate, however, in case of an insulating substrate made of material such as sapphire, a conductivity type layer (n-type layer 23 in a constitution of Fig. 2) of a lower layer is exposed by removing a part of laminated semiconductor layers by etching, and an electrode is formed on the exposed portion. In addition, in case of using a semiconductor substrate, an n-type substrate is used and an n-type layer is formed as a lower layer in the above-described example, however the substrate and the lower layer may be formed so as to have a p-type conductivity type. And, a material of the buffer layer 22 is not limited to the AlGaN based compound and other nitride semiconductor layer may be used. When the substrate is an insulating substrate, connection to the pair of the electrode films 11 and 12 which is provided on the insulating substrate 1 described above, is carried out by wire bonding for both. However, even in case of forming both electrodes at a surface side such as in case of using an insulating substrate, connection can be carried out not by wire bonding but by an adhesive directly by referring to Fig. 4.

Furthermore, the n-type layer 23 and the p-type layer 25 are not limited to a GaN layer described above, AlGaN based compound or the like may be used, and, in stead of forming each of the layers with single layer, complex layers can be formed which are formed with a material which can easily confine carriers such as AlGaN based compound having large band gap energy at an active layer side and a GaN layer or the like which is apt to raise carrier concentration at an opposite side of the active layer. In addition, a material for the active layer 24 is selected depending upon a desired wavelength of light, a structure is not limited to a MQW structure and a SQW structure or a bulk layer may be formed. Furthermore, a material of the light transmitting conductive layer 26 is not limited to ZnO, but ITO or a thin alloy film having a thickness of 2 to 100 nm made of Ni and Au alloy can be used, and a material which can transmit light and diffuse electric current to whole part of a chip can be used. A Ni-Au layer is formed thin since the metal layer looses light transmissivity when the layer is formed thick, however, the ZnO or ITO layer can be allowed to be thick because they transmit light.

By die-bonding the LED chip 2, for example, on the first electrode film 11 through a conductive adhesive 3a (connection means 3), an electrode of the substrate side (n-side electrode 28) of the LED chip 2 is connected electrically to the first electrode film 11 and an upper electrode (p-side electrode 27) is connected electrically to the second electrode film 12 with a wire 3b (connection means 3) made of, for example, Au or the like. When the LED chip 2 is formed by laminating nitride semiconductor layers on an insulating substrate, both electrodes are connected electrically with wires or by die-bonding by a face down manner as shown in Fig. 4. The first and second resin layers 4 and 5 described above are formed by depositing so as to coat a surrounding of the LED chip 2. The first and second resin layers 4 and 5 can be formed very precisely on the LED chip 2 of a very small size by depositing a resin by a transfer method described later.

Subsequently, an explanation will be given below of a method of the white light emitting device in reference to explanatory figures of production process shown in Fig. 1. Here, Figs. 1(a) to (c) show cross-sectional views at A-A of Fig. 1(f) and Figs. 1(d) to (e) show cross-sectional views at B-B of Fig. 1(f), respectively. First of all, a pair of electrode films 11 and 12 is formed on an insulating substrate 1 as shown in Figs. 1(a). A large insulating substrate 1 is used in order to manufacture a plurality of the devices at one time as described above, the pair of electrode films 11 and 12 is formed on a surface thereof by printing conductive paste such as Ag paste or the like by a screen printing or the like, and, at the same time, back surface electrode films 11a and 12a are formed at the end portion side of the back surface of the insulating substrate 1, corresponding to the pair of electrode films 11 and 12.

Subsequently, as shown in Fig. 1(b), the LED chip 2 emitting blue or ultraviolet light is mounted on one of the pair of electrode films 11 and 12 or on a surface of the insulating substrate 1, and a pair of electrodes (p-side electrode and n-side electrode) of the LED chip 2 is connected electrically to the pair of electrode films 11 and 12 respectively. In an example shown in Fig. 1, the n-side electrode of the LED chip 2 is connected to a first electrode film 11 with a conductive adhesive 3a (connection means 3), and the p-side electrode (upper electrode) is connected electrically to a second electrode film 12 by a bonding wire 3b (connection means 3).

Thereafter, as shown in Fig. 1(c), a reflecting case 6 made of a resin of, for example, a liquid crystal polymer type resin is stuck around each device. The reflecting case 6 reflects light traveling in a lateral direction to an upper surface side in order to emit light emitted from the LED chip 2 to the upper surface side together, and is made of white resin or the like which reflects light easily. In case of emitting light also in a lateral direction without limiting to emitting to an upper surface side, it is not necessary to provide the reflecting case 6.

Then, as shown in Fig. 1(d), a resin containing a red color conversion member 4a for converting blue or ultraviolet light emitted in the LED chip 2 into red light is deposited by a transfer method. Namely, the resin 4 containing the red color conversion member described above is attached to a top end portion of a transfer pin 7 of a needle shape, which has an area of the top end of approximately 0.008 mm² and is made of titanium alloy, the top end portion is contacted with a side or a corner part of the LED chip 2, thereby the resin 4 attached to the top end portion of the transfer pin 7 is transferred to the LED chip 2. By using this method, since a quantity of the resin 4 attached is constant corresponding to an area of the top end of the transfer pin 7, the quantity of the resin deposited on the LED chip 2 can be constant. As a result, even on the LED chip 2 of a small size, the resin can be deposited so as to coat substantially half thereof. As a coating method, in place of the transfer method, the resin of a desired quantity can be projected, for example, by a dispenser or the like, however, it is preferable to use the transfer method in order to deposit the resin to coat precisely the LED chip 2, since the quantity of the resin to be deposited is approximately 0.0003 mm³.

Here, in case that the wire 3b is spread to the electrode of the upper surface of the LED chip 2, in order to prevent the transfer pin from contacting with the wire 3b, the transfer pin is brought close from one of both sides interposing a plane which is formed along a direction of spreading the wire 3b (direction of extending the wire 3b), and is contacted with a side of the LED chip 2 (in case that the wire is spread in a direction parallel to a side of the LED chip 2) or a corner (in case that the wire is spread to a corner side of the LED chip 2), thereby the resin can be transferred to the LED chip 2 precisely without contacting of the transfer pin 7 with the wire 3b.

Subsequently, in the same manner by using the resin containing a green color conversion member, the second resin layer 5 contacted closely with the LED chip 2 is formed by transferring the resin to the other half side of the LED chip 2. At this time, although a portion where the first resin layer 4 is overlapped exists at a center part of the LED chip 2, it is allowed to be overlapped. Because the light which was converted in light color is not converted again if the first resin layer 4 containing a red color conversion member is deposited first. It is not necessary that deposition of the resin for forming the second resin layer 5 is carried out only after the first resin layer 5 was dried, and actually, a resin can be deposited continuously and alternately to the light emitting chip portions formed on the large insulating substrate 1 in longitudinal and lateral directions.

Thereafter, the large insulating substrate 1 is cut and divided into each device, side electrodes (not shown in figures) are formed by painting conductive paste such as Ag paste on sides of the insulating substrate 1 and dried so as to connect the pair of electrode films 11 and 12 to the back surface electrodes 11a and 12a, thereby, a white semiconductor light emitting device of a chip type can be obtained. The side electrodes may be connected previously by providing through holes in the insulating substrate. The electrode films or the like are formed by a vacuum evaporation method, an electric plating method or the like in place of using conductive paste. In addition, whole chip may be coated with a light transmitting resin further after the first and second resin layers 4 and 5 are formed. It is efficient for protecting the wire if the wire 3b is not coated perfectly with the first and second resin layers 4 and 5.

Fig. 3 shows an example of not the light emitting device of a chip type but a light emitting device of a lamp type, and (a) is a cross-sectional view of a direction perpendicular to (b). Namely, a recess 8c is formed at a top end of a lead 8a of a pair of leads 8a and 8b, a LED chip 2 is die-bonded within the recess 8c, one electrode thereof is connected electrically to the first lead 8a with a conductive adhesive 3a, and the other electrode is connected electrically to the second lead 8b with a wire 3b. After carrying out this wire bonding, the first resin layer 4 is formed by the transfer method in the same manner described above, the second resin layer 5 is formed thereafter, a mold resin portion 9 is formed by molding a light transmitting resin on a whole upper portion of the leads 8a and 8b, thereby a white semiconductor light emitting device of a lamp type can be obtained. In addition, the same letters and numerals are attached to the same parts as those of the example shown in Fig. 1, and the explanation is omitted.

Fig. 4 is an explanatory cross-sectional view showing an example of a variation of a constitution shown in Fig. 1. Namely, this is the example in which semiconductor layers of a LED chip 2 are formed on an insulating substrate, and a pair of electrodes is formed at a surface side (the pair of electrodes can be formed even if the substrate is not an insulating substrate but a semiconductor substrate). And, a pair of electrodes 27 and 28 of the LED chip 2 is bonded directly to the pair of electrode films 11 and 12 formed on the insulating substrate 1 with a conductive adhesive not shown in the figure, other parts are the same as those of the example shown in Fig. 1 described above, and the same letters and numerals are attached to the same parts as those of the example shown in Fig. 1, and the explanation is omitted. In this example, since wire bonding is not carried out, depositing by a transfer pin can be easily carried out without worrying about contacting with a wire even in case of forming the first resin layer 4 or the second resin layer 5 by depositing.

According to the embodiment of the present invention in which the resin layer for light color conversion is deposited, since the fist resin layer containing the red color conversion member and the second resin layer containing the green color conversion member are provided around the LED chip emitting blue light so as to coat each substantially half of the LED chip, the light emitted by the LED chip can be converted into the red light and the green light without wasting, the light converted into green light is not converted further into red light because the two layers are separated from each other, and the red light and the green light which are converted and the blue light not converted are mixed, thereby white light color can be obtained. Furthermore, since a quantity of depositing the resin can be adjusted depending upon an area of a top end of the transfer pin, a very small quantity of the resin can be divided into two parts and deposited even on the LED chip of a small size. As a result, since light of desired color can be mixed with a precise quantity without wasting of light, a white light with excellent color rendering property can be emitted stably, and, at the same time, a white semiconductor light emitting device with excellent external quantum efficiency can be obtained.

Subsequently, an explanation will be given below of the white semiconductor light emitting device according to the present invention in which the resin layer containing a light color conversion member is formed directly on the LED chip by molding. As an explanatory cross-sectional view of an example is shown in Fig. 5(e), the light emitting element chip (hereinafter referred to as LED chip) 2 emitting, for example, the blue light is mounted on the insulating substrate 1 which is provided with a pair of electrode films 11 and 12 at both ends thereof, and a pair of electrodes of the LED chip 2 is connected electrically to a pair of electrode films (first and second electrode film) 11 and 12 with connection means 3 respectively. The first resin layer 4 is provided by coating a surrounding of the LED chip 2 and the connection means 3 with the mold resin containing the red color conversion member 4a for converting blue light emitted from the LED chip 2 into the red light and the second resin layer 5 is provided by coating a surrounding of the first resin layer 4 with the mold resin containing the green color conversion member 5a for converting the blue light emitted from the LED chip 2 into the green light.

For the first resin layer 4, there is used a material which is made by mixing the red color conversion member 4a absorbing light having a shorter wavelength than that of the red light and converting into the red light to a usual light transmitting and moldable resin, for example, such as an epoxy resin. Since a light color conversion member absorbs light having a shorter wavelength than that corresponding to the band gap energy thereof as described above, and emits light corresponding to the band gap energy thereof, the resin containing the red color conversion member 4a for converting into the red light which has the longest wavelength among red, green and blue light of three primary light colors is used for the first resin layer 4 contacting with the LED chip 2 in the present invention. As a result, although the portion of overlapping of the second resin layer 5 exists, the red light which is obtained by absorbing a part of the blue light emitted in the LED chip 2 and converting into the red light is not absorbed by the second resin layer 5.

For the second resin layer 5, a material which is made by mixing the green color conversion member 5a to a light transmitting mold resin such as an epoxy resin or the like in the same manner, is used, and, for the green color conversion member 5a, same material as that in the above-described example can be used.

In addition, in the example shown in Fig. 1, since a chip emitting blue light is used as the LED chip 2, the first and second resin layers 4 and 5 converting into the red light and the green light respectively are provided by double molding, however, when a chip emitting, for example, ultraviolet light is used as the LED chip 2, a third resin layer may be formed further on an outer periphery of the second resin layer 5 with a mold resin containing a blue color conversion member for converting into the blue light. Thereby, the ultraviolet light emitted from the LED chip 2 is converted into the red, green and blue light of three primary colors, and the white light is obtained by mixing them. In this case, as the blue color conversion member, a halophosphate fluorescent material, an aluminate fluorescent material, a silicate fluorescent material or the like can be used, and as an activator, cerium, europium, manganese, gadolinium, samarium, terbium, tin, chromium, antimony or the like can be used.

The insulating substrate 1, the LED chip 2 or the like is same as that of the example shown in Fig. 1, and the explanation thereof is omitted. And even in case that the LED chip 2 emit ultraviolet light, the light can be emitted by using nitride semiconductor or zinc oxide based compound in the same manner, and the white light can be obtained by tri-mold using red, green and blue color conversion members. In addition, when the substrate of the LED chip 2 is made of an insulating substrate, both electrodes are connected by wire bonding, and the first resin layer 4 is formed so as to coat both wires. Then, the first and second resin layers 4 and 5 described above are formed by injecting the above-described resin by a transfer mold method or an injection mold method or the like, while setting the insulating substrate 1 within a molding die.

Subsequently, an explanation will be given below of a method for manufacturing the white light emitting device in reference to Fig. 5. Here, Figs. 5(a) and 5(b) are same as Fig. 1(a) and Fig. 1(b), the same letters and numerals are attached to the same parts, and the explanation is omitted. Thereafter, as shown in Fig. 5(c), the first resin layer 4 is formed with the resin containing the red color conversion member 4a for converting the blue or ultraviolet light emitted from the LED chip 2 into the red light, by carrying out a first molding of a surrounding of the LED chip, for example, by a transfer mold method. The first resin layer 4 is formed on plenty of LEDs 2 formed on a large insulating substrate 1 together so as to coat perfectly a portion of the wire 32 of each of the LED chips 2 which is wire-bonded, and has a very small size such that (length) × (width) × (height) is approximately (0.3 mm) × (0.5 mm) × (0.25 mm).

Then, the second resin layer 5 is formed around the first resin layer 4 so as to contact closely to each other by carrying out second transfer molding or the like using the resin containing the green color conversion member. The second resin layer 5 has a size such that (length) × (width) × (height) is approximately (0.6 mm) × (0.0.8 mm) × (0.4 mm), and is formed very thin since an interval distance between the first resin layer 4 and the molding die is approximately 0.2 mm.

Thereafter, similarly to the example shown in Fig. 1, the large substrate is divided into each device by cutting, and side electrodes 11b and 12b are formed by depositing conductive paste such as Ag paste on sides of the insulating substrate 1 so as to connect the pair of electrodes 11 and 12 to the back surface electrodes 11a and 12a, thereby the white semiconductor light emitting device of a chip type can be obtained. Here, the side electrode may be connected previously by forming through holes in the insulating substrate. The electrode film or the like may be formed by a vacuum evaporation method, an electric plating method or the like in place of using conductive paste, similarly to the above-described example.

Fig. 6 is an example of a variation of Fig. 5, and shows that the first resin layer 4 is formed not in a rectangular solid shape but with a step. In other words, it is preferable to form the resin containing the light color conversion member so as to contact as closely as possible to a LED chip 2 and be thin because attenuation of the light can be inhibited and external quantum efficiency can be improved, however the first resin layer 4 is required to coat a portion of the wire 32 perfectly at a portion where wire bonding is carried out. Therefore, since a quantity of the resin of the first resin layer 4 becomes much at the portion of the wire, a quantity of the resin of the first resin layer 4 is decreased at a portion where the wire does not exist by forming an outer shape of the first resin layer 4 not in a rectangular shape but stepwise, and, on the contrary, a quantity of the resin of the second resin layer 5 is increased correspondingly. Other parts are same as those of the example shown in Fig. 5, the same letters and numerals are attached to the same parts, and the explanation is omitted.

Fig. 7 is an explanatory cross-sectional view showing an example of another variation of a constitution shown in Fig. 5. Namely, the example shows a case such that the LED chip 2 is formed by growing semiconductor layers on the insulating substrate, a pair of electrodes is formed at a surface side (a pair of electrodes can be formed at a surface side even on a semiconductor substrate in place of an insulating substrate), a pair of electrodes 27 and 28 of the LED chip 2 is bonded directly to the pair of electrode films 11 and 12 provided on a surface of the insulating substrate 1 with the conductive adhesive not shown in the figure, and other parts are same as those in examples shown in Figs. 5 and 6 described above. Then the same letters and numerals are attached to the same parts, and the explanation is omitted. In this example, since wire bonding is not carried out, it is not necessary to extend the resin at a wire portion at the time of primary molding, thereby the first and second resin layers 4 and 5 can be formed very compact.

According to the present invention in which the resin layers 4 and 5 are formed by molding, since the resin layer containing the light color conversion member is formed around the LED chip emitting the blue or ultraviolet light by molding, the white light with excellent color rendering property can be emitted while inhibiting attenuation of the light emitted from the LED chip, because the resin layer can be formed with very precise quantity of the resin and very thin. Further, according to this example, since the first resin layer coating the LED chip contains the red color conversion member and the second resin layer coating a surrounding of the first resin layer contains the green color conversion member, there is no wasting such that the light converted from the blue or ultraviolet light is converted again by other light color conversion member, thereby external quantum efficiency can be improved further more.

### INDUSTRIAL APPLICABILITY

The present invention can be used for light sources of a wide field such as backlights for liquid display devices or the like, light emitting devices of various kinds for white light, blue light or the like, and lighting devices or the like.

## Claims

1. A white semiconductor light emitting device comprising:
an insulating substrate which is provided with a pair of electrode films at both ends thereof;
a light emitting element chip emitting blue light mounted on the insulating substrate;
connection means connecting electrically a pair of electrodes of the light emitting element chip and the pair of electrode films of the insulating substrate respectively;
a first resin layer made of resin containing a red color conversion member for converting the blue light emitted by the light emitting element chip into red light, the first resin layer being provided so as to coat substantially half of the light emitting element chip and to be in close contact with the light emitting element chip; and
a second resin layer made of resin containing a green color conversion member for converting the blue light emitted by the light emitting element chip into green light, the second resin layer being provided so as to coat the other substantially half of the light emitting element chip and to be in close contact with the light emitting element chip.

2. The white semiconductor light emitting device according to claim 1, wherein the pair of electrodes of the light emitting element chip is formed at a surface side, the pair of electrodes of the light emitting element chip is connected directly to the pair of electrode films with a conductive adhesive by turning a back surface of a substrate of the light emitting element chip upside, and the first and second resin layers are provided so as to coat the back surface of the substrate of the light emitting element chip.

3. A white semiconductor light emitting device comprising:
a first lead which is provided with a recess of a curved shape at an end part thereof;
a second lead arranged in parallel to the first lead;
a light emitting element chip emitting blue light mounted in the recess of the first lead;
connection means connecting electrically a pair of electrodes of the light emitting element chip and the first and second leads respectively;
a first resin layer made of resin containing a red color conversion member for converting the blue light emitted by the light emitting element chip into red light, the first resin layer being provided so as to coat substantially half of the light emitting element chip and to be in close contact with the light emitting element chip; and
a second resin layer made of resin containing a green color conversion member for converting the blue light emitted by the light emitting element chip into green light, the second resin layer being provided so as to coat the other substantially half of the light emitting element chip and to be in close contact with the light emitting element chip.

4. The white semiconductor light emitting device according to claim 1 or 3, wherein at least one of the connection means is constituted of a wire which connects one electrode of the light emitting element chip and one of the pair of the electrodes, and the first resin layer and the second resin layer are formed divided approximately by a dividing plane which is perpendicular to a surface of the light emitting element chip in a direction of extending the wire.

5. A white semiconductor light emitting device comprising:
an insulating substrate which is provided with a pair of electrode films at both ends thereof;
a light emitting element chip emitting blue or ultraviolet light mounted on the insulating substrate;
connection means connecting electrically a pair of electrodes of the light emitting element chip and the pair of electrode films of the insulating substrate respectively;
a first resin layer made of mold resin containing a red color conversion member for converting the blue or ultraviolet light emitted by the light emitting element chip into red light, the first resin layer being provided to coat a portion of the light emitting element chip and the connection means; and
a second resin layer made of mold resin containing a green color conversion member for converting the blue or ultraviolet light emitted by the light emitting element chip into green light, the second resin layer being provided to coat a surrounding of the first resin layer.

6. The white semiconductor light emitting device according to claim 5, wherein one of the pair of electrodes which are formed on the light emitting element chip is formed at a back surface side of the chip, thereby one of the connection means is an adhesive with which the light emitting element chip is bonded on one of the pair of electrode films, the other of the connection means is a wire for wire bonding to the other of the pair of electrode films, the first resin layer is formed so as to be thick at a side where the wire for wire bonding exists and thin at a side where the wire does not exist, and the second resin layer is formed so as to be thin at the side where the wire for wire bonding exists and thick at the side where the wire does not exist.

7. A method for manufacturing a white semiconductor light emitting device in which blue light is converted into white light by providing a resin containing a light color conversion member on a surface of a light emitting element chip emitting blue light, comprising the steps of:
forming the light emitting element chip approximately in a shape of a cube or a rectangular solid;
forming a first resin layer by contacting a transfer pin with a side or a corner of a surface of the light emitting element chip and by transferring a resin so as to coat substantially half of the light emitting element chip, the transfer pin being attached with the resin containing a red color conversion member for converting the blue light emitted by the light emitting element chip into red light; and
forming a second resin layer by contacting a transfer pin with a side or a corner opposite to the side or the corner of the surface of the light emitting element chip and by transferring a resin so as to coat the other substantially half of the light emitting element chip, the transfer pin being attached with the resin containing a green color conversion member for converting the blue light emitted by the light emitting element chip into green light.

8. The method for manufacturing a white semiconductor light emitting device according to claim5, wherein a wire is bonded on at least one of the electrodes of the light emitting element chip, and the first and second resin layers are formed by contacting the transfer pins with the light emitting element chip from both sides of the wire.

9. A method for manufacturing a white semiconductor light emitting device comprising the steps of:
forming a pair of electrode films on an insulating substrate;
mounting a light emitting element chip emitting blue or ultraviolet light on one of the pair of electrode films or a surface of the insulating substrate;
connecting electrically a pair of electrodes of the light emitting element chip and the pair of electrode films respectively;
forming a first resin layer by molding primarily a surrounding of the light emitting element chip with a resin containing a red color conversion member for converting the blue or ultraviolet light emitted by the light emitting element chip into red light; and
forming a second resin layer by molding secondly a surrounding of the first resin layer with a resin containing a green color conversion member for converting the blue or ultraviolet light emitted by the light emitting element chip into green light.
